(19) Europäisches Patentamt / European Patent Office / Office européen des brevets

(11) **EP 3 767 314 B1**

(12) **EUROPEAN PATENT SPECIFICATION**

(45) Date of publication and mention of the grant of the patent:
**30.08.2023 Bulletin 2023/35**

(21) Application number: **19187156.5**

(22) Date of filing: **18.07.2019**

(51) International Patent Classification (IPC):
**G01R 31/08** (2020.01)     **H02J 3/36** (2006.01)
**G01R 31/11** (2006.01)

(52) Cooperative Patent Classification (CPC):
**G01R 31/086;** G01R 31/11; H02J 3/36; Y02E 60/60;
Y04S 10/52

(54) **FAULT LOCATION IN AN HVDC SYSTEM**

FEHLERLOKALISIERUNG IN EINEM HVDC-SYSTEM

LOCALISATION DE PANNES DANS UN SYSTÈME HVDC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.01.2021 Bulletin 2021/03**

(73) Proprietor: **Hitachi Energy Switzerland AG 5400 Baden (CH)**

(72) Inventors:
• **Bjorklund, Hans**
  **77143 Ludvika (SE)**
• **Burek, Arkadiusz**
  **77143 Ludvika (SE)**

(74) Representative: **Epping - Hermann - Fischer Patentanwaltsgesellschaft mbH Schloßschmidstraße 5 80639 München (DE)**

(56) References cited:
**WO-A1-2011/069548     GB-A- 1 571 802**

• **PHILIPP TUNNERHOFF ET AL: "Comprehensive Fault Type Discrimination Concept for Bipolar Full-Bridge-Based MMC HVDC Systems with Dedicated Metallic Return", IEEE TRANSACTIONS ON POWER DELIVERY., vol. 33, no. 1, 28 February 2018 (2018-02-28), pages 330-339, XP055508956, US ISSN: 0885-8977, DOI: 10.1109/TPWRD.2017.2716113**

• **XU PENG ET AL: "Research on the Fault Location Principle for the Earthing Electrode Line of the UHVDC Transmission System", ENERGY AND POWER ENGINEERING, vol. 05, no. 04, 31 January 2013 (2013-01-31), pages 1198-1201, XP055662741, US ISSN: 1949-243X, DOI: 10.4236/epe.2013.54B227**

## Description

TECHNICAL FIELD

The present invention relates to location of faults in an HVDC system with a Dedicated Metallic Return conductor or an Electrode Line.

BACKGROUND

High Voltage Direct Current (HVDC) transmission is used for point to point transmission of large amount of bulk power over long distance. Recent advancement in converter technology has further increased the power carrying capacity of HVDC transmission.

In typical solutions for HVDC transmission, an Earth and electrode line is used as a return path. During the operation, the DC ground potential rises, which sometimes has adverse effects on buried objects, induced current in pipelines and neighbor metal construction can suffer faster corrosion.

A Dedicated Metallic Return (DMR) line can be used to eliminate the ground return current, to carry unbalanced current and/or to apply low insulation level. An HVDC transmission system with a DMR conductor for monopolar operation is applied if there are restrictions even to temporary use of electrodes, or if the transmission distance is relatively short. A Low Voltage Direct Current (LVDC) metallic conductor can be considered as an alternative to the ground return path with electrodes.

During normal operation of HVDC system in a bipolar mode, the current in the DMR conductor is perfectly balanced and is close to zero (in practice, it reaches only a few amperes). It means that if the DMR conductor fails (for example, a weak HVDC tower insulation may lead to grounding of the HV conductor via the tower structures), it is difficult to detect the failure (earthing) of the DMR conductor just by observing only positive or negative pole currents or voltages via instrument transformers or sensors that are installed in stations at both ends of DC lines.

Measurement of current at the beginning of the DMR conductor does not provide good results for detection of the earthing of the DMR conductor. It allows only checking of the DMR conductor status for safety reason before each switching operation to monopole mode.

A positive or negative pole main cable failure or outage could lead to a full outage of the HVDC system.

An article by P. Tünnerhoff et al., titled "Comprehensive Fault Type Discrimination Concept for Bipolar Full-Bridge-Based MMC HVDC Systems with Dedicated Metallic Return", IEEE Transactions on Power Delivery, Vol. 33(1), February 2018, discloses an approach for identifying different faults in and between conductors of a MMC HVDS system, i.e. pole-GND faults, DMR-GND faults, pole-DMR faults, pole-DMR-GND faults, pole-pole faults and pole-pole-GND faults.

A European patent application EP2706364 discloses an electrode line monitoring unit for monitoring an electrode line that comprises: a communications device including a transmitter to transmit, in use, a signal; and a power supply including a power extraction circuit for connection, in use, into the electrode line such that a voltage drop is generated across the power extraction circuit so as to provide a primary voltage source to power one or more other components of the electrode line monitoring unit, wherein the power extraction circuit includes at least one power electronic device with a non-linear voltage-current characteristic.

A Chinese patent application CN103744001 discloses a frequency domain method of fault location of a high-voltage direct current earth electrode line based on a distributed parameter model.

A European patent application EP2510599 discloses a fault detection system for detection of line faults on an electrode line in an HVDC system wherein the electrode line comprises a first and second branch connected in parallel. The fault detection system comprises a first and second pulse generation circuit arranged to generate electrical pulses onto the first and second branches, respectively, as well as first and second current measurement devices arranged to generate signals indicative of electrical signals occurring in first and second injection lines, respectively.

A European patent application EP0360109 discloses a converter station in a high voltage direct current power transmission with an electrode line protective device for detection of ground faults on the electrode line of the station. An alternating voltage generator injects an alternating signal with a predetermined frequency in the electrode line.

A publication "Research on the Fault Location Principle for the Earthing Electrode Line of the UHVDC Transmission System" (Xu Peng, Yu Jiang, Energy and Power Engineering, 2013, 5, 1198-1201) discloses monitoring an earthing electrode line operation in a UHVDC transmission line.

Therefore, there is a need for a method for fast detection and accurate location of faults in the DMR or Electrode Line during monopole operation.

SUMMARY

The object of the invention is a controller for a High Voltage Direct Current (HVDC) system, the HVDC system comprising two stations between which power is conducted via a pair of conductors connected between converters acting as rectifiers and inverters and a Dedicated Metallic Return (DMR) conductor or an Electrode Line (EL) installed between the neutral points of the stations, wherein the controller comprises a converter firing controller controlled by a control subsystem and configured to output valve firing pulses according to a converter firing control sequence to the converters to generate a balanced current flow in the conductors, characterized in that: the control subsystem is configured to alter the converter firing control sequence generated by the firing controller such as to introduce unbalance of current flow in the DMR or EL and the controller further comprises a fault locator configured to locate faults by measuring the current flowing in the DMR or EL.

The fault locator may be integrated with the control subsystem of the controller.

The fault locator may be integrated with a protection subsystem of the controller.

The fault locator may be connected to the control subsystem and to a protection subsystem of the controller.

Another object of the invention is a method for locating faults in a High Voltage Direct Current (HVDC) system, the HVDC system comprising two stations between which power is conducted via a pair of conductors connected between rectifiers and inverters and a Dedicated Metallic Return (DMR) conductor or an Electrode Line (EL) installed between the neutral points of the stations and a controller comprising a converter firing controller controlled by a control subsystem for generating output valve firing pulses according to a converter firing control sequence to the converters to generate a balanced current flow in the conductors, characterized in that the method comprises: modifying at least one firing pulse generated by the converter firing controller such as to cause unbalance in the current of the DMR OR EL; measuring the current flowing in the DMR or EL to detect a fault; calculating the position of the fault in the DMR or EL from the beginning of the DMR or EL by measuring times of impulses propagated in the DMR or EL after the modification of the converter firing control sequence and calculating the time difference ($\Delta T$) between two following pulses to the measuring point at the beginning of the DMR or EL and multiplies it by a half of the DMR or EL propagation velocity calculated based on the RLCG parameters of the DMR or EL.

## BRIEF DESCRIPTION OF FIGURES

The present invention is shown by means of example embodiment on a drawing, wherein:

Fig. 1 shows a single line diagram of a bipolar HVDC system with a DMR conductor;
Figs. 2A-2C shows example embodiments of a structure of the HVDC controller;
Fig. 3 shows a alternation of firing pulses;
Fig. 4 shows a current unbalance observed at the DMR conductor;
Fig. 5 shows voltages after alternation of the firing pulse;
Fig. 6 shows currents after alternation of the firing pulse;
Fig. 7 shows a current unbalance observed at the DMR conductor without faults;
Fig. 8 shows a current unbalance observed at the faulty DMR conductor;

Fig. 9 shows a line diagram of a bipolar HVDC system with an Electrode Line.

## DETAILED DESCRIPTION

The method presented herein relates to locating faults in a HVDC transmission system with a DMR conductor or an Electrode Line. It requires only simple changes in a control unit of the HVDC system, without a need to install any additional power electronic devices. The additional function in the HVDC control system monitors the current signal in the DMR or Electrode Line at one or two converter stations and measures a pulse that appears in DMR conductor after activation of the additional control function described herein.

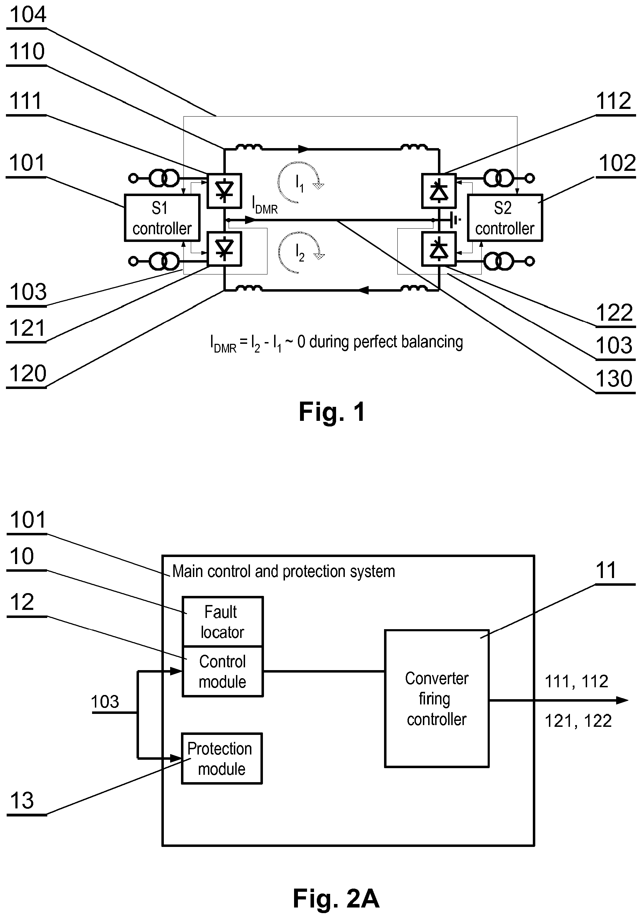

Fig. 1 shows a single line diagram of a bipolar HVDC system with a DMR conductor.

The system comprises two stations S1, S2, between which power is conducted via a pair of conductors: a positive pole conductor 110 and a negative pole conductor 120, configured to transmit DC power at high potential with respect to the ground. Each line 110, 120 is terminated with a converter (a rectifier 111, 121 at one side and an inverter 112, 122 at an opposite side). A Dedicated Metallic Return (DMR) conductor 130 is connected between the neutral points of the stations S1, S2.

The operation of the HVDC system is controlled by main controllers 101, 102, (such as MACH control unit by ABB). A part of a example structures of the controller 101, 102 is shown in Figs. 2A-2C.

The controller 101, 102 comprises a conventional control subsystem 12 and a conventional protection subsystem 13, as known in the controllers of this type. A converter firing controller 11 is used to generate valve firing pulses to control operation of the valves in the converters 111, 112, 121, 122 and is controlled by the control subsystem 12. The control subsystem 12 and the protection subsystem 13 have access to HVDC measurement data, including the current measurement 103 in the DMR conductor.

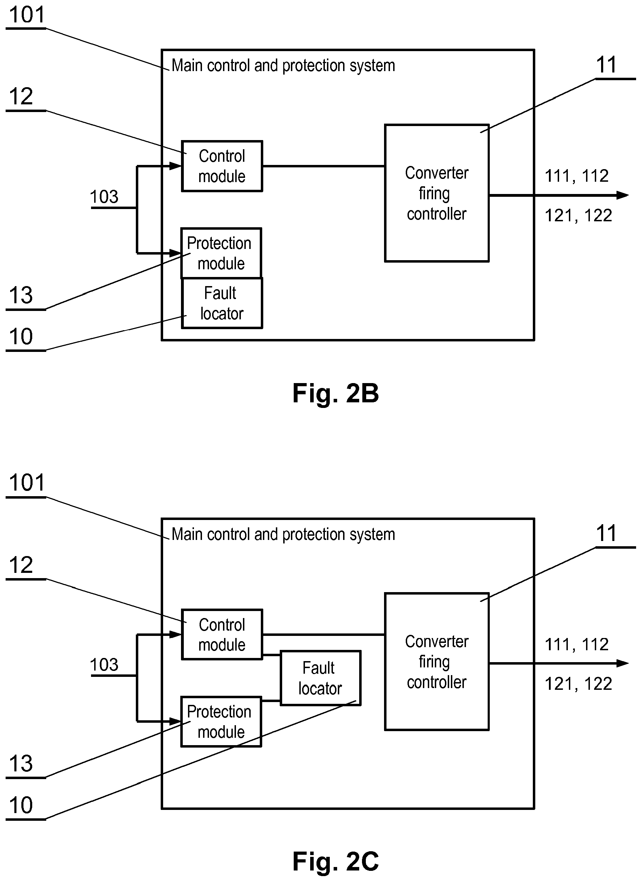

In addition, the controller 101, 102 of the present invention comprises a fault locator module 10, which can be incorporated in the control subsystem 12 (as shown in Fig. 2A) or in the protection subsystem 13 (as shown in Fig. 2B) or between these systems (as shown in Fig. 2C, such that it accesses measurement data from the protection subsystem 13 and outputs its measurement results to the control subsystem 12).

In typical operation, regular valve firing pulses are generated to balance the current flow in the DC lines 110, 120.

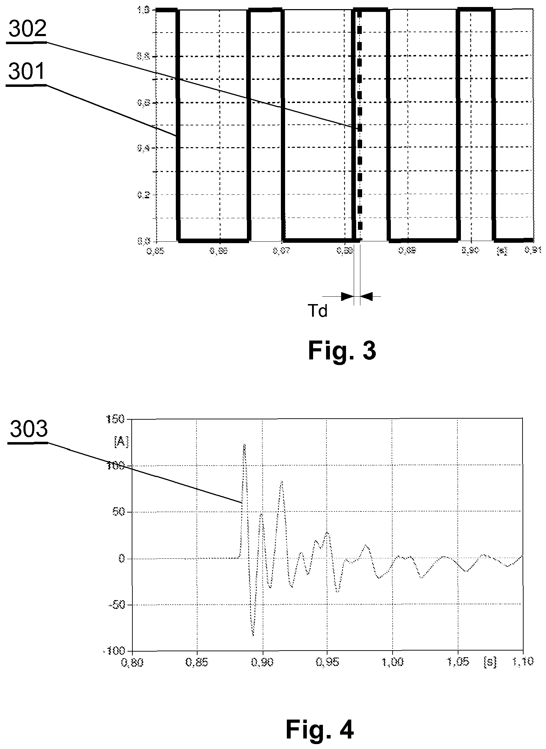

The fault locator 10 is configured to alter the regular generation of the converter firing controller 11 to introduce unbalance between the current flow in the DC lines 110, 120. For example, it can shorten or lengthen, or shift in time, one firing pulse of the series of the regular pulses. As a result, unbalance current will appear in the DMR or Electrode Line. The current at the beginning of the DMR or Electrode line is monitored by one of the subsystems 12, 13. In normal, balanced operation, the monitored or measured current 103 shall be close to zero. When the pulses are altered (as shown in Fig. 3), unbalance is observed in the monitored current (as shown in Fig. 4). Analysis of the unbalanced current can be performed at the fault locator 10 to determine whether there is a fault in the line and where it is located.

The above-described principles can be demonstrated with an example related to operation of a HVDC line with a DMR 130 such as shown in Fig. 1, with 6-pulse converters 111, 112, 121, 122. As shown in Fig. 3, a regular firing pulse sequence 301 for one arm of the 6-pulse converter can be altered by the fault locator 10 by delaying initiation of one pulse 302 by a delay time Td, thereby making it shorter by Td, for example by 1 ms. This results in an unbalance of the current 303 observed at the DMR conductor 130 by the fault locator 10, as shown in Fig. 4.

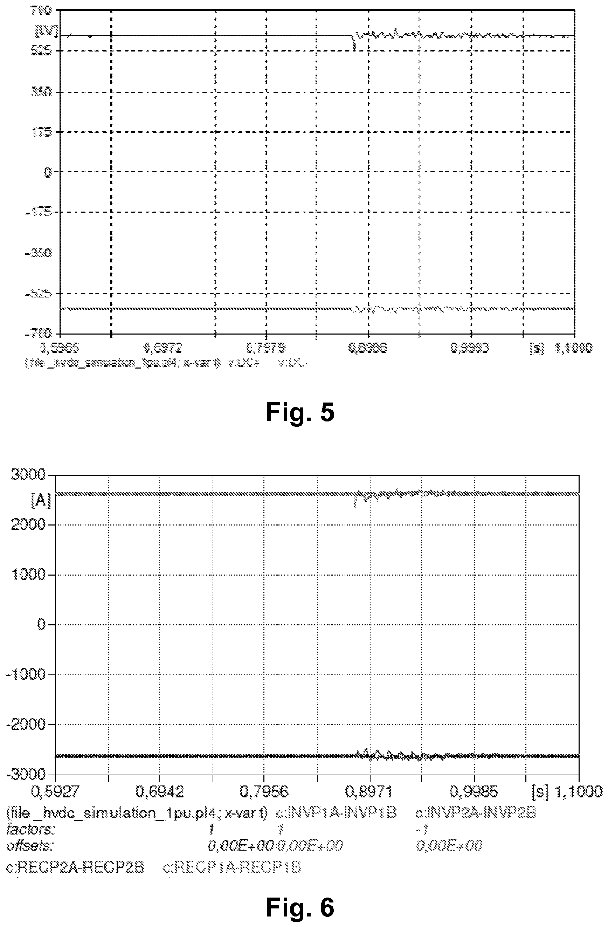

Fig. 5 shows voltages and Fig. 6 shows currents at the DC lines 110, 120 during the introduced unbalance. As clearly visible, the voltages and currents are relatively stable after the intentionally introduced unbalance and come back to normal conditions relatively quickly. Therefore, the proposed method is not dangerous to the normal operation of HVDC system.

The level of DMR current pulse can be selected depending to the length of the DMR conductor in order to be visible after reaching end of DMR conductor (or not dumped in long cable lines) and to not disturb the signals (currents and voltages) in the main DC lines 110, 120, such as not to trigger any protection function.

The pulses in the measured current are damped and can be used to estimate the status of DMR conductor. Calculation of two consecutive pulses can give the information that the DMR is grounded and it is also possible to calculate where it is earthed/grounded. The fault location can be based on estimation of the arriving times of travelling waves that are propagating along the DMR conductor from beginning to the faulted point and back to the measurement point.

First, times $T_{M1}$ and $T_{M2}$ of measured impulses from the DMR conductor signal shall be calculated. Based on the known DMR conductor RLCG parameters (wherein R is the resistive loss of the conductor; L is the inductive part of the circuit; C is the capacitive part of the circuit; and G is the shunt loss of the dielectric), the V-wave propagation velocity can be calculated as:

$$v = \sqrt{(R + j\omega L)(G + j\omega C)}$$

$$\Delta T = T_{M1} - T_{M2}$$

The faulted place to earth fault ($X_M$) is calculated as:

$$X_M = \frac{1}{2} v \Delta T$$

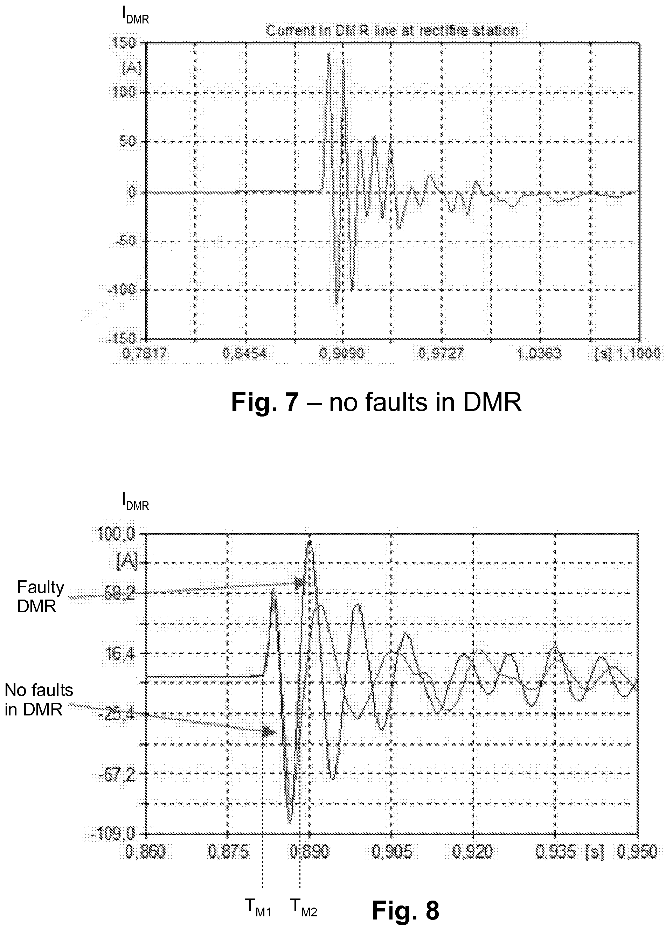

Fig. 7 shows an example of current measurement at the DMR conductor 130 of a fault-free line after introduction of the unbalance. Fig. 8 shows a comparative plot of current measurement at the DMR 130 of a DMR line with no faults and a faulty DMR conductor, wherein the signal for a faulty line indicates an impulse that arrives at a time $T_{M2}$ earlier than for the signal with a line with no faults.

This method can be used for short DMR conductors, wherein the measurement can be performed at one of the stations S1, S2 (single-end measurement). For longer DMR conductors, a double-end measurement may be performed, i.e. at both stations S1, S2.

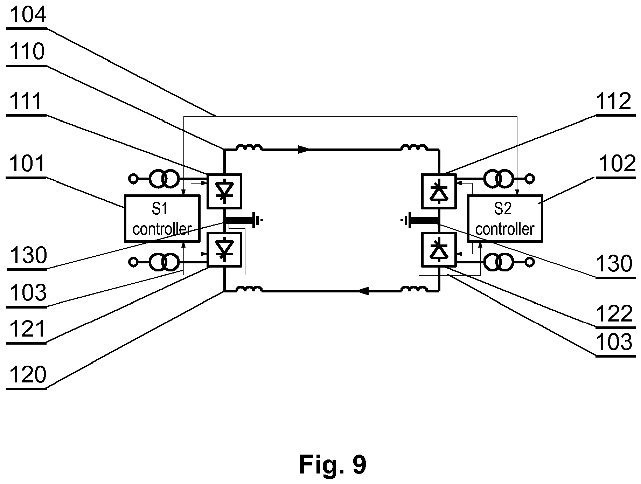

A similar approach can be used in Electrode Lines, for corresponding RLCG parameters of the Electrode Line, as shown in Fig. 9.

## Claims

1. A controller (101,102) for a High Voltage Direct Current, HVDC, system, the HVDC system comprising two stations (S1, S2) between which power is conducted via a pair of conductors (110; 120) connected between converters (111, 112, 121, 122) acting as rectifiers (111, 121) and inverters (112, 122) and a Dedicated Metallic Return, DMR, conductor (130) or an Electrode Line, EL, installed between the neutral points of the stations (S1, S2), wherein the controller (101,102) comprises a converter firing controller (11) controlled by a control subsystem (12) and configured to output valve firing pulses according to a converter firing control sequence to the converters (111, 112, 121, 122) to generate a balanced current flow in the conductors (110; 120), **characterized in that**:

   - the control subsystem (12) is configured to alter the converter firing control sequence generated by the firing controller (11) such as to introduce unbalance of current flow in the DMR conductor (130) or EL; and
   - the controller (101, 102) further comprises a fault locator (10) configured to locate faults by measuring the current (103) flowing in the DMR conductor (130) or EL.

2. The controller according to claim 1, wherein the fault locator (10) is integrated with the control subsystem (12) of the controller (101, 102).

3. The controller according to claim 1, wherein the fault locator (10) is integrated with a protection subsystem (13) of the controller (101, 102).

**4.** The controller according to claim 1, wherein the fault locator (10) is connected to the control subsystem (12) and to a protection subsystem (13) of the controller (101, 102).

**5.** The controller according to any one of claims 1 to 4, wherein the fault locator (10) is configured to calculate the position of the fault in the DMR conductor (130) or EL from the beginning of the DMR conductor (130) or EL by measuring times of impulses propagated in the DMR conductor (130) or EL after the modification of the converter firing control sequence and calculating the time difference ($\Delta T$) between two following pulses to the measuring point at the beginning of the DMR conductor (130) or EL and multiplies it by a half of the DMR conductor (130) or EL propagation velocity calculated based on the RLCG parameters of the DMR conductor (130) or EL.

**6.** A High Voltage Direct Current, HVDC, system, comprising

- two stations (S1, S2) between which power is conducted via a pair of conductors (110; 120) connected between converters (111, 121, 112, 122) acting as rectifiers (111,121) and inverters (112, 122), and
- a Dedicated Metallic Return, DMR, conductor (130) installed between the neutral points of the stations (S1, S2),
- wherein at least one of the two stations (S1, S2) comprises a controller (101, 102) according to one of claims 1 to 5.

**7.** A High Voltage Direct Current, HVDC, system, comprising

- two stations (S1, S2) between which power is conducted via a pair of conductors (110; 120) connected between converters (111, 121, 112, 122) acting as rectifiers (111,121) and inverters (112, 122), and
- an Electrode Line, EL, installed between the neutral points of the stations (S1, S2),
- wherein at least one of the two stations (S1, S2) comprises a controller (101, 102) according to one of claims 1 to 5.

**8.** The HVDC system according to claim 6 or 7, wherein each one of the two stations (S1, S2) comprises a controller (101, 102) according to one of claims 1 to 5, and wherein the system is configured to perform a double-end measurement to locate faults.

**9.** A method for locating faults in a High Voltage Direct Current, HVDC, system, the HVDC system comprising two stations (S1, S2) between which power is conducted via a pair of conductors (110; 120) connected between converters (111, 121, 112, 122) acting as rectifiers (111,121) and inverters (112, 122) and a Dedicated Metallic Return, DMR, conductor (130) or an Electrode Line, EL, installed between the neutral points of the stations (S1, S2) and a controller (101, 102) comprising a converter firing controller (11) controlled by a control subsystem (12) for generating output valve firing pulses according to a converter firing control sequence to the converters (111,112,121, 122) to generate a balanced current flow in the conductors (110; 120), **characterized in that** the method comprises:

- modifying at least one firing pulse generated by the converter firing controller (11) such as to cause unbalance in the current of the DMR conductor (130) or EL;
- measuring the current (103) flowing in the DMR conductor (130) or EL to detect a fault;
- calculating the position of the fault in the DMR conductor (130) or EL from the beginning of the DMR conductor (130) or EL by measuring times of impulses propagated in the DMR conductor (130) or EL after the modification of the converter firing control sequence and calculating the time difference ($\Delta T$) between two following pulses to the measuring point at the beginning of the DMR conductor (130) or EL and multiplying it by a half of the DMR conductor (130) or EL propagation velocity calculated based on the RLCG parameters of the DMR conductor (130) or EL.

**10.** The method of claim 9, wherein the method is performed during normal operation of the HVDC system.

**Patentansprüche**

**1.** Controller (101, 102) für ein Hochspannungs-Gleichstrom-(HVDC)-System, wobei das HVDC-System zwei Stationen (S1, S2) umfasst, zwischen denen Strom über ein Paar von Leitern (110, 120), die zwischen Umrichtern (111, 112, 121, 122) angeschlossen sind, die als Gleichrichter (111, 121) und Wechselrichter (112, 122) wirken, und einen dedizierten metallischen Rückleiter (DMR) (130) oder eine Elektrodenleitung (EL), die zwischen den Neutralpunkten der Stationen (S1, S2) verlegt sind, geleitet wird, wobei der Controller (101, 102) einen Umrichterzündungsregler (11) umfasst, der von einem Steuerungsteilsystem (12) gesteuert wird und so konfiguriert ist, dass er Ventilzündimpulse gemäß einer Umrichterzündsteuerungssequenz an die Umrichter (111, 112, 121, 122) ausgibt, um einen ausgeglichenen Stromfluss in den Leitern (110, 120) zu erzeugen, **dadurch gekennzeichnet, dass**:

- das Steuerungsteilsystem (12) so konfiguriert ist, dass es die von dem Zündungsregler (11) erzeugte Umrichterzündsteuerungssequenz so ändert, dass eine Unsymmetrie des Stromflusses im DMR-Leiter (130) oder EL entsteht; und
- der Controller (101, 102) ferner einen Fehlerdetektor (10) umfasst, der so konfiguriert ist, dass er Fehler durch Messen des in dem DMR-Leiter (130) oder EL fließenden Stroms (103) lokalisiert.

2. Controller nach Anspruch 1,
   wobei der Fehlerdetektor (10) in das Steuerungsteilsystem (12) des Controllers (101, 102) integriert ist.

3. Controller nach Anspruch 1,
   wobei der Fehlerdetektor (10) in ein Schutzteilsystem (13) des Controllers (101, 102) integriert ist.

4. Controller nach Anspruch 1,
   wobei der Fehlerdetektor (10) mit dem Steuerungsteilsystem (12) und mit einem Schutzteilsystem (13) des Controllers (101, 102) verbunden ist.

5. Controller nach einem der Ansprüche 1 bis 4,
   wobei der Fehlerdetektor (10) für Folgendes konfiguriert ist:

   Berechnen der Position des Fehlers im DMR-Leiter (130) oder in der EL vom Anfang des DMR-Leiters (130) oder der EL aus durch Messen der Zeiten von Impulsen, die sich im DMR-Leiter (130) oder in der EL nach der Änderung der Umrichterzündsteuerungssequenz ausbreiten, und
   Berechnen der Zeitdifferenz (ΔT) zwischen zwei aufeinanderfolgenden Impulsen zum Messpunkt am Anfang des DMR-Leiters (130) oder der EL, und
   Multiplizieren mit der halben Ausbreitungsgeschwindigkeit des DMR-Leiters (130) oder der EL, berechnet auf der Grundlage der RLCG-Parameter des DMR-Leiters (130) oder der EL.

6. Hochspannungs-Gleichstrom-(HVDC)-System, das Folgendes umfasst:

   - zwei Stationen (S1, S2), zwischen denen Strom über ein Paar von Leitern (110, 120) geleitet wird, die zwischen Umrichtern (111, 121, 112, 122) angeschlossen sind, die als Gleichrichter (111, 121) und Wechselrichter (112, 122) fungieren, und
   - einen dedizierten metallischen Rückleiter (DMR) (130), der zwischen den Neutralpunkten der Stationen (S1, S2) verlegt ist,
   - wobei mindestens eine der beiden Stationen (S1, S2) einen Controller (101, 102) nach einem der Ansprüche 1 bis 5 aufweist.

7. Hochspannungs-Gleichstrom-(HVDC)-System, das Folgendes umfasst:

   - zwei Stationen (S1, S2), zwischen denen Strom über ein Paar von Leitern (110, 120) geleitet wird, die zwischen Umrichtern (111, 121, 112, 122) angeschlossen sind, die als Gleichrichter (111, 121) und Wechselrichter (112, 122) fungieren, und
   - eine Elektrodenleitung (EL), die zwischen den Neutralpunkten der Stationen (S1, S2) installiert ist,
   - wobei mindestens eine der beiden Stationen (S1, S2) einen Controller (101, 102) nach einem der Ansprüche 1 bis 5 aufweist.

8. HVDC-System nach Anspruch 6 oder 7,

   wobei jede der beiden Stationen (S1, S2) einen Controller (101, 102) nach einem der Ansprüche 1 bis 5 umfasst, und
   wobei das System so konfiguriert ist, dass es eine Doppelendmessung zur Lokalisierung von Fehlern durchführt.

9. Verfahren zur Lokalisierung von Fehlern in einem Hochspannungs-Gleichstrom-(HVDC)-System, wobei das HVDC-System zwei Stationen (S1, S2), zwischen denen Strom über ein Paar von Leitern (110, 120), die zwischen Umrichtern (111, 121, 112, 122) angeschlossen sind, die als Gleichrichter (111, 121) und Wechselrichter (112, 122) wirken, und einen dedizierten metallischen Rückleiter (DMR) (130) oder eine Elektrodenleitung (EL), die zwischen den Neutralpunkten der Stationen (S1, S2) verlegt sind, geleitet wird, und einen Controller (101, 102) umfasst, wobei der Controller (101, 102) einen von einem Steuerungsteilsystem (12) gesteuerten Umrichterzündungsregler (11) zur Erzeugung von Ausgangsventil-Zündimpulsen gemäß einer Umrichterzündsteuerungssequenz für die Umrichter (111, 112, 121, 122) umfasst, um einen ausgeglichenen Stromfluss in den Leitern (110, 120) zu erzeugen, **dadurch gekennzeichnet, dass** das Verfahren Folgendes umfasst:

   - Modifizieren mindestens eines vom Umrichterzündungsregler (11) erzeugten Zündimpulses, um eine Unsymmetrie im Strom des DMR-Leiters (130) oder EL zu verursachen;
   - Messen des Stroms (103), der im DMR-Leiter (130) oder EL fließt, um einen Fehler zu erkennen;
   - Berechnen der Position des Fehlers im DMR-Leiter (130) oder in der EL vom Anfang des DMR-Leiters (130) oder der EL aus durch Messen der Zeiten von Impulsen, die sich im DMR-Leiter (130) oder in der EL nach der Änderung der Umrichterzündsteuerungssequenz ausbreiten, und

- Berechnen der Zeitdifferenz (AT) zwischen zwei aufeinanderfolgenden Impulsen zum Messpunkt am Anfang des DMR-Leiters (130) oder der EL und Multiplizieren mit der halben Ausbreitungsgeschwindigkeit des DMR-Leiters (130) oder der EL, die auf der Grundlage der RLCG-Parameter des DMR-Leiters (130) oder der EL berechnet wird.

10. Verfahren nach Anspruch 9,
    wobei das Verfahren während des normalen Betriebs des HVDC-Systems durchgeführt wird.

**Revendications**

1. Contrôleur (101,102) pour un système à Courant Continu Haute Tension, CCHT, le système CCHT comprenant deux postes (S1, S2) entre lesquels la puissance est conduite via une paire de conducteurs (110 ; 120) connectés entre des convertisseurs (111, 112, 121, 122) jouant le rôle de redresseurs (111, 121) et d'inverseurs (112, 122) et un conducteur de Retour Métallique Dédié, RMD, (130) ou une Ligne d'Electrode, LE, installé(e) entre les points neutres des postes (S1, S2), le contrôleur (101, 102) comprenant un contrôleur d'allumage des convertisseurs (11) commandé par un sous-système de commande (12) et configuré pour produire des impulsions d'allumage de valve selon une séquence de commande d'allumage des convertisseurs à destination des convertisseurs (111, 112, 121, 122) pour générer un flux de courant équilibré dans les conducteurs (110 ; 120), **caractérisé en ce que** :

   - le sous-système de commande (12) est configuré pour modifier la séquence de commande d'allumage des convertisseurs générée par le contrôleur d'allumage (11) de façon à introduire un déséquilibre du flux de courant dans le conducteur RMD (130) ou la ligne LE ; et
   - le contrôleur (101, 102) comprend en outre un localisateur de panne (10) configuré pour localiser des pannes en mesurant le courant (103) circulant dans le conducteur RMD (130) ou la ligne LE.

2. Contrôleur selon la revendication 1, dans lequel le localisateur de panne (10) est intégré à un sous-système de commande (12) du contrôleur (101, 102).

3. Contrôleur selon la revendication 1, dans lequel le localisateur de panne (10) est intégré à un sous-système de protection (13) du contrôleur (101, 102).

4. Contrôleur selon la revendication 1, dans lequel le localisateur de panne (10) est connecté au sous-système de commande (12) et à un sous-système de protection (13) du contrôleur (101, 102).

5. Contrôleur selon l'une quelconque des revendications 1 à 4, dans lequel le localisateur de panne (10) est configuré pour calculer la position de la panne dans le conducteur RMD (130) ou la ligne LE par rapport au début du conducteur RMD (130) ou de la ligne LE par mesure des temps de propagation des impulsions dans le conducteur RMD (130) ou la ligne LE après la modification de la séquence de commande d'allumage des convertisseurs et calcul de la différence de temps ($\Delta T$) entre deux impulsions consécutives allant vers le point de mesure, au début du conducteur RMD (130) ou de la ligne LE, et multiplication de celle-ci par la moitié de la vitesse de propagation dans le conducteur RMD (130) ou la ligne LE calculée à partir des paramètres RLCG du conducteur RMD (130) ou de la ligne LE.

6. Système à Courant Continu Haute Tension, CCHT, comprenant

   - deux postes (S1, S2) entre lesquels la puissance est conduite via une paire de conducteurs (110 ; 120) connectés entre des convertisseurs (111, 121, 112, 122) jouant le rôle de redresseurs (111, 121) et d'inverseurs (112, 122), et
   - un conducteur Retour Métallique Dédié, RMD, (130) installé entre les points neutres des postes (S1, S2),
   - au moins l'un des deux postes (S1, S2) comprenant un contrôleur (101, 102) selon l'une des revendications 1 à 5.

7. Système à Courant Continu Haute Tension, CCHT, comprenant

   - deux postes (S1, S2) entre lesquels la puissance est conduite via une paire de conducteurs (110 ; 120) connectés entre des convertisseurs (111, 121, 112, 122) jouant le rôle de redresseurs (111, 121) et d'inverseurs (112, 122), et
   - une Ligne d'Electrode, LE, installée entre les points neutres des postes (S1, S2),
   - au moins l'un des deux postes (S1, S2) comprenant un contrôleur (101, 102) selon l'une des revendications 1 à 5.

8. Système CCHT selon la revendication 6 ou 7, dans lequel chacun des deux postes (S1, S2) comprend un contrôleur (101, 102) selon l'une des revendications 1 à 5, et dans lequel le système est configuré pour exécuter une double mesure d'extrémité pour localiser les pannes.

9.  Procédé de localisation de pannes dans un système à Courant Continu Haute Tension, CCHT, le système CCHT comprenant deux postes (S1, S2) entre lesquels la puissance est conduite via une paire de conducteurs (110 ; 120) connectés entre des convertisseurs (111, 121, 112, 122) jouant le rôle de redresseurs (111, 121) et d'inverseurs (112, 122) et un conducteur de Retour Métallique Dédié, RMD, (130) ou une Ligne d'Electrode, LE, installé(e) entre les points neutres des postes (S1, S2), et un contrôleur (101, 102) comprenant un contrôleur d'allumage des convertisseurs (11) commandé par un sous-système de commande (12) pour générer des impulsions d'allumage de valve selon une séquence de commande d'allumage des convertisseurs à destination des convertisseurs (111, 112, 121, 122) pour générer un flux de courant équilibré dans les conducteurs (110 ; 120), **caractérisé en ce que** le procédé comprend :

    - la modification d'au moins une impulsion d'allumage générée par le contrôleur d'allumage des convertisseurs (11) de façon à provoquer un déséquilibre dans le courant du conducteur RMD (130) ou de la ligne LE ;
    - la mesure du courant (103) circulant dans le conducteur RMD (130) ou la ligne LE pour détecter une panne ;
    - le calcul de la position de la panne dans le conducteur RMD (130) ou la ligne LE par rapport au début du conducteur RMD (130) ou de la ligne LE par mesure des temps de propagation des impulsions dans le conducteur RMD (130) ou la ligne LE après la modification de la séquence de commande d'allumage des convertisseurs et calcul de la différence de temps ($\Delta T$) entre deux impulsions consécutives allant vers le point de mesure, au début du conducteur RMD (130) ou de la ligne LE, et multiplication de celle-ci par la moitié de la vitesse de propagation dans le conducteur RMD (130) ou la ligne LE calculée à partir des paramètres RLCG du conducteur RMD (130) ou de la ligne LE.

10. Procédé selon la revendication 9, dans lequel le procédé est exécuté pendant un fonctionnement normal du système CCHT.

$$I_{DMR} = I_2 - I_1 \sim 0 \text{ during perfect balancing}$$

**Fig. 1**

**Fig. 2A**

**Fig. 2B**

**Fig. 2C**

302

301

Td

**Fig. 3**

303

**Fig. 4**

EP 3 767 314 B1

**Fig. 5**

(file _hvdc_simulation_1pu.pl4; x-var t) c:INVP1A-INVP1B     c:INVP2A-INVP2B
factors:                              1         1              -1
offsets:                         0,00E+00 0,00E+00        0,00E+00
c:RECP2A-RECP2B   c:RECP1A-RECP1B

**Fig. 6**

12

**Fig. 7** – no faults in DMR

**Fig. 8**

104

110

111

112

101

102

130

130

103

122

121

103

120

S1
controller

S2
controller

**Fig. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2706364 A
- CN 103744001
- EP 2510599 A
- EP 0360109 A

**Non-patent literature cited in the description**

- **P. TÜNNERHOFF et al.** Comprehensive Fault Type Discrimination Concept for Bipolar Full-Bridge-Based MMC HVDC Systems with Dedicated Metallic Return. *IEEE Transactions on Power Delivery,* February 2018, vol. 33 (1
- **XU PENG ; YU JIANG.** Research on the Fault Location Principle for the Earthing Electrode Line of the UHVDC Transmission System. *Energy and Power Engineering,* 2013, vol. 5, 1198-1201